# EUROPEAN PATENT SPECIFICATION

(11) **EP 4 700 804 B1**
(45) Date of publication and mention of the grant of the patent: **09.09.2026**
(21) Application number: 24212457.6
(22) Date of filing: 12.11.2024
(51) Int. Cl.: H01F 27/02, H01F 27/06, H01F 27/16, H01F 27/18, H01F 37/00, H05K 7/20

(54) **ENERGY STORAGE CONVERTER AND ENERGY STORAGE DEVICE**
ENERGIESPEICHERWANDLER UND ENERGIESPEICHERVORRICHTUNG
CONVERTISSEUR DE STOCKAGE D'ÉNERGIE ET DISPOSITIF DE STOCKAGE D'ÉNERGIE

(30) Priority: 19.08.2024 CN 202411132003
(43) Date of publication of application: 25.02.2026
(73) Proprietor: Zhejiang Jinko Energy Storage Co., Ltd., Jiaxing, Zhejiang (CN)
(72) Inventor: YU, Jian, Jiaxing (CN); ZHANG, Luhua, Jiaxing (CN)
(74) Representative: DREISS Patentanwälte PartG mbB

(56) References cited:
- WO-A1-2023/116617
- JP-A- 2013 229 433
- US-A1- 2010 209 314
- US-A1- 2013 182 478
- US-A1- 2016 125 996
- US-A1- 2023 411 071

## Description

### TECHNICAL FIELD

The present disclosure relates to the technical field of energy storage, and in particular, to an energy storage converter and an energy storage device.

### BACKGROUND

An energy storage converter can control charging and discharging processes of a battery, perform AC and DC conversion, and can directly supply power to an AC load when there is no power grid. The energy storage converter is provided with an inductor and a cooling plate for a cooling purpose. In the related art, the inductor is placed in an inductor box roughly in a shape of a cuboid, and the inductor box is placed on the cooling plate. Provided prior documents US2016125996A1, and WO2023116617A1 are considered as relevant.

### SUMMARY

The present disclosure provides an energy storage converter and an energy storage device. The invention is set out in the appended set of claims.

Some embodiments of the present disclosure provide an energy storage converter, including: a mounting box; an inductor; and a cooling plate. The mounting box includes a mounting cavity, the inductor is mounted in the mounting cavity, and the mounting box is mounted to the cooling plate. The mounting box includes a bottom wall, one of the bottom wall and the cooling plate is provided with a heat dissipation protrusion and the other one of the bottom wall and the cooling plate is provided with a heat dissipation groove, and the heat dissipation protrusion is engaged with the heat dissipation groove. The mounting box includes a first side wall and a second side wall opposite to each other, the first side wall includes a first surface facing away from the second side wall, the second side wall includes a second surface facing away from the first side wall, and a distance between the first surface and the second surface gradually increases along a direction towards the cooling plate.

In a possible implementation, a plurality of heat dissipation protrusions and/or a plurality of heat dissipation grooves are arranged along an axial direction of the inductor.

In a possible implementation, the first surface and/or the second surface is provided with a heat dissipation rib, and the heat dissipation rib extends from an end of the first surface or the second surface away from the cooling plate towards an end close to the cooling plate.

In a possible implementation, a width of the heat dissipation rib increases along the direction towards the cooling plate; and/or a height of the heat dissipation rib protruding from the first side wall or the second side wall increases along the direction towards the cooling plate.

A thickness of the first side wall and/or the second side wall increases along the direction towards the cooling plate. In a possible implementation, a receiving cavity in a shape of a triangular prism is formed in the first side wall and/or the second side wall, and a liquid cooling medium is received in the receiving cavity, the cooling medium being capable of being transformed to be a gaseous state when a preset temperature is reached.

In a possible implementation, the inductor includes a main body and end portions, the end portions being arranged at two sides of the main body. The mounting box is provided with: a first support portion, the first support portion including an arc surface capable of supporting the main body; and a second support portion, the second support portion being arranged at each of two sides of the first support portion along an axial direction of the inductor, the second support portion being a support rib, and the support rib being capable of supporting each of the end portions.

In a possible implementation, an angle α is formed between the first surface and/or the second surface and a vertical direction, and the angle α satisfies 5°≤α≤30°.

In a possible implementation, the mounting box includes a third side wall and a fourth side wall opposite to each other, the third side wall include a third surface facing away from the fourth side wall, the fourth side wall includes a fourth surface facing away from the third side wall, and a distance between the third surface and the fourth surface increases along the direction towards the cooling plate.

In a possible implementation, the mounting box includes avoidance grooves, and the avoidance grooves are arranged at a junction of the first side wall with the third side wall, at a junction of the first side wall with the fourth side wall, at a junction of the second side wall with the third side wall, and at a junction of the second side wall with the fourth side wall. The bottom wall includes a mounting surface at a side facing each of the avoidance grooves, the mounting surface is provided with a mounting hole, and a connecting member passes through the mounting hole to be connected to the cooling plate.

Some embodiments of the present disclosure provide an energy storage device, including a body and the energy storage converter described above.

In the present disclosure, the inductor may generate heat during operation. The heat can be conducted to the cooling plate through the mounting box. The cooling plate absorbs the heat to cool the inductor so that the inductor can operate at an appropriate temperature. The cooling plate is provided therein with a flow channel, and coolant at a lower temperature is introduced into the flow channel. One or more inductors may be received in the mounting cavity. The engagement of the heat dissipation protrusion with the heat dissipation groove increases an area of contact between the bottom wall and the cooling plate, thereby improving a heat dissipation effect of the cooling plate on the inductor. At the same time, the engagement of the heat dissipation protrusion with the heat dissipation groove can limit movement of the mounting box relative to the cooling plate, so that a position of the mounting box relative to the cooling plate is determined, thereby achieving a limiting effect. A shape of the flow channel arranged in the cooling plate corresponding to the mounting box matches a shape of the heat dissipation protrusion or the heat dissipation groove, so that a heat transfer effect between the cooling plate and the mounting box is more balanced. Along the direction towards the cooling plate, a distance between the first surface and the second surface gradually increases, so that an area of a surface of the bottom wall facing the cooling plate is larger, that is, the area of contact between the bottom wall and the cooling plate is larger. As a result, heat exchange efficiency between the mounting box and the cooling plate is higher, and the cooling plate has a better heat dissipation effect on the inductor.

It should be understood that the general description above and the detailed description in the following are merely exemplary and cannot limit the present disclosure.

### BRIEF DESCRIPTION OF DRAWINGS

FIG. 1 is a schematic structural diagram of a mounting box, an inductor, and a cooling plate in an energy storage converter according to an embodiment of the present disclosure;
FIG. 2 is a partial sectional view of the mounting box, the inductor, and the cooling plate shown in FIG. 1 according to some embodiments of the present disclosure;
FIG. 3 is a partial sectional view of the mounting box, the inductor, and the cooling plate shown in FIG. 1 according to some other embodiments of the present disclosure;
FIG. 4 is a sectional view of the cooling plate shown in FIG. 1;
FIG. 5 is a schematic structural diagram of the mounting box and the inductor shown in FIG. 1;
FIG. 6 is a schematic structural diagram of the inductor shown in FIG. 5;
FIG. 7 is a schematic structural diagram of the mounting box shown in FIG. 5; and
FIG. 8 is a side view of FIG. 5.

### Reference signs:

1: mounting box;
   1a: mounting cavity;
   1b: receiving cavity;
   11: first side wall;
   12: second side wall;
   13: third side wall;
   14: fourth side wall;
   15: bottom wall;
      151: heat dissipation protrusion;
      152: mounting surface;
      153: mounting hole;
      16: first support portion;
      17: second support portion;
      18: heat dissipation rib;
      19: avoidance groove;
2: inductor;
   21: main body;
   22: end portion;
3: cooling plate;
31: flow channel;
32: heat dissipation groove.

The accompanying drawings herein, which are incorporated in and constitute part of this specification, illustrate embodiments consistent with the present disclosure and, together with the specification, serve to explain principles of the present disclosure.

### DESCRIPTION OF EMBODIMENTS

For better illustrating the technical solutions of the present disclosure, embodiments of the present disclosure will be described in detail below with reference to the accompanying drawings.

It should be clear that the described embodiments are only some of rather than all of the embodiments of the present disclosure. Based on the embodiments in the present disclosure, all other embodiments obtained by those of ordinary skill in the art without creative efforts fall within a scope of the present disclosure.

The terms used in the embodiments of the present disclosure are for the purpose of describing particular embodiments only, and are not intended to limit the present disclosure. As used in the embodiments of the present disclosure and the appended claims, the singular forms of "a" and "the" may also include plural forms, unless otherwise clearly indicated in the context.

It should be understood that the term "and/or" used herein is merely an association relationship describing associated objects, indicating that there may be three relationships, for example, A and/or B may indicate that three cases, i.e., A existing individually, A and B existing simultaneously, B existing individually. In addition, the character "/" herein generally indicates that the related objects before and after the character form an "or" relationship.

It should be noted that, the expressions such as "upper", "lower", "left", "right" and the like mentioned in embodiments of the present disclosure are described with reference to the placement status in the accompanying drawings, and should not be construed as limiting embodiments of the present disclosure. In addition, it should also be understood that, in the context, while referring to an element being formed "above" or "below" another element, it is possible that the element is directly formed "above" or "below" the other element, it is also possible that the element is formed "above" or "below" the other element via an intermediate element.

Some embodiments of the present disclosure provide an energy storage device, for example, an energy storage container. The energy storage device includes a body, in which a plurality of independent battery compartments and a device compartment are usually provided. The battery compartment is provided therein with a battery rack. A plurality of battery packs are placed at the battery rack. The device compartment is provided therein with an energy storage converter. The energy storage converter can control charging and discharging processes, convert AC to DC, and directly supply an AC load when there is no power grid.

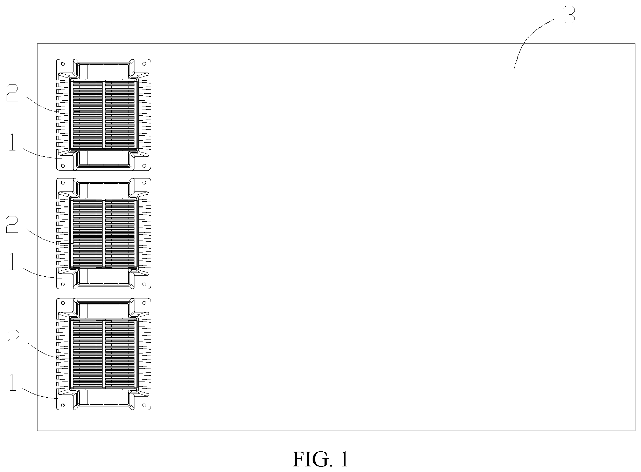

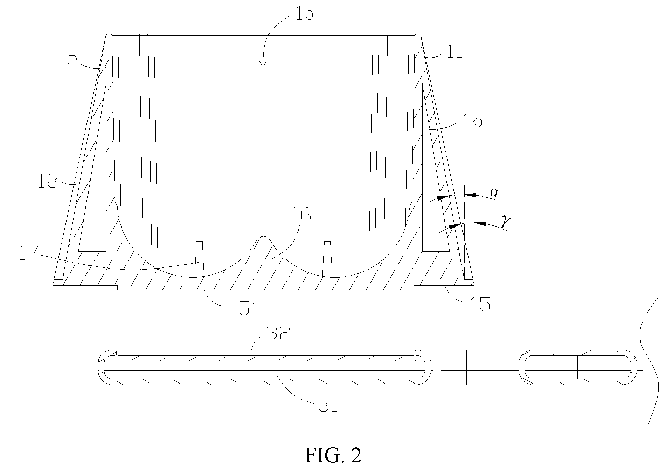

Some embodiments of the present disclosure provide an energy storage converter. As shown in FIG. 1 and FIG. 2, the energy storage converter includes a mounting box 1, an inductor 2, and a cooling plate 3. The mounting box 1 includes a mounting cavity 1a, the inductor 2 is mounted in the mounting cavity 1a, and the mounting box 1 is mounted at the cooling plate 3. The inductor 2 may generate heat during operation. The heat can be transferred to the cooling plate 3 through the mounting box 1. The cooling plate 3 absorbs the heat and cools the inductor 2, so that the inductor 2 can operate at an appropriate temperature.

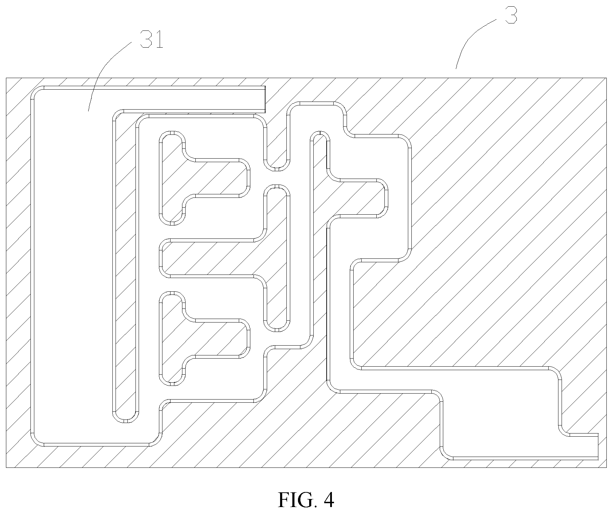

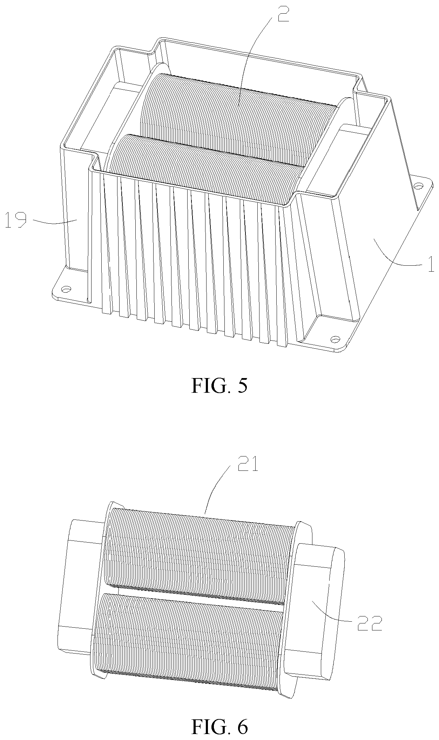

As shown in FIG. 4, the cooling plate 3 is provided therein with a flow channel 31, and coolant at a low temperature is introduced into the flow channel 31. As shown in FIG. 6, one or more inductors 2 may be received in the mounting cavity 1a. For example, in some embodiment of the present disclosure, two inductor coils are received in the mounting cavity 1a to serve as a main body 21 of the inductor 2, axial directions of the two inductor coils are parallel to each other (this direction is defined as an axial direction of the inductor 2), end portions 22 are provided at two sides of the two inductor coils along the axial direction, and the end portions 22 are connected to the two inductor coils. In some embodiments, the axial direction of the inductor 2 is parallel to a length direction of the mounting box 1.

As shown in FIG. 2, the mounting box 1 includes a bottom wall 15. One of the bottom wall 15 and the cooling plate 3 is provided with a heat dissipation protrusion 151, and the other one of the bottom wall 15 and the cooling plate 3 is provided with a heat dissipation groove 32. The heat dissipation protrusion 151 is engaged with the heat dissipation groove 32, to increase an area of contact between the bottom wall 15 and the cooling plate 3 and improve a heat dissipation effect of the cooling plate 3 on the inductor 2. At the same time, the engagement of the heat dissipation protrusion 151 with the heat dissipation groove 32 can limit movement of the mounting box 1 relative to the cooling plate 3, so that a position of the mounting box 1 relative to the cooling plate 3 is determined, thereby achieving a limiting effect.

In some embodiments, the heat dissipation groove 32 is arranged at the cooling plate 3, and the heat dissipation protrusion 151 is arranged at the bottom wall of the mounting box 1. In some other embodiments, the heat dissipation groove 32 is arranged at the bottom wall 15 of the mounting box 1, and the heat dissipation protrusion 151 is arranged at the cooling plate 3.

In some embodiments, as shown in FIG. 2, the heat dissipation protrusion 151 is a large protrusion, and the heat dissipation groove 32 is a large groove matching a size of the heat dissipation protrusion 151. This structure has advantages of a simple structure and easy manufacturing.

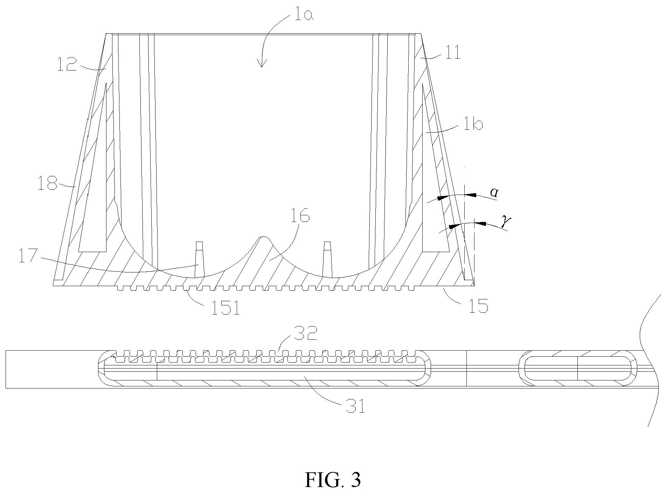

In some embodiments, as shown in FIG. 3, the heat dissipation protrusion 151 is formed by a plurality of protruding heat dissipation teeth, and the heat dissipation groove 32 is formed by small a plurality of grooves matching the plurality of heat dissipation teeth. An extension direction of the heat dissipation protrusion 151 and an extension direction of the heat dissipation groove 32 may be parallel to a length direction of the mounting box 1, or parallel to a width direction of the mounting box 1, or is at an angle with the length direction of the mounting box 1.

Further, a thermal conductive glue may be applied to the heat dissipation protrusion 151 and the heat dissipation groove 32, and a gap between the heat dissipation protrusion 151 and the heat dissipation groove 32 is filled with the thermal conductive glue, to achieve an higher heat transfer efficiency between the cooling plate 3 and the mounting box 1 to ensure a heat dissipation effect on the inductor 2.

Furthermore, a shape of the flow channel 31 arranged at the cooling plate 3 corresponding to the mounting box 1 matches a shape of the heat dissipation protrusion 151 or the heat dissipation groove 32, so that a heat transfer effect between the cooling plate 3 and the mounting box 1 is more balanced. That is, if the heat dissipation groove 32 in the cooling plate 3 is a larger-sized groove, the flow channel 31 corresponding to the mounting box 1 is also provided with a structure of a larger-sized groove; and if the heat dissipation groove 32 in the cooling plate 3 is formed by a plurality of small grooves, the flow channel 31 corresponding to the mounting box 1 is also provided with a structure of a plurality of smaller-sized grooves.

In addition, edges of the heat dissipation protrusion 151 and the heat dissipation groove 32 are rounded, to reduce mutual wearing when the mounting box 1 fits the cooling plate 3.

As shown in FIG. 2 and FIG. 3, the mounting box 1 includes a first side wall 11 and a second side wall 12 opposite to each other, the first side wall 11 includes a first surface facing away from the second side wall 12, the second side wall 12 includes a second surface facing away from the first side wall 11, and a distance between the first surface and the second surface gradually increases along a direction towards the cooling plate 3, so that an area of a surface of the bottom wall 15 facing the cooling plate 3 is larger, that is, the area of contact between the bottom wall 15 and the cooling plate 3 is larger. As a result, heat exchange efficiency between the mounting box 1 and the cooling plate 3 is higher, and the cooling plate 3 has a better heat dissipation effect on the inductor 2.

For example, the first surface and/or the second surface may form an angle α with a vertical direction, and the angle α satisfies 5°≤α≤30°. For example, the angle α may be 5°, 8°, 10°, 12°, 15°, 18°, 20°, 22°, 25°, 28°, 30°, or the like.

The angle α formed between the first surface and/or the second surface and the vertical direction should not be excessively large or excessively small. If the angle α is excessively large (e.g., greater than 30°), the mounting box 1 may occupy an excessively large space, making it more difficult to arrange the mounting box 1 at the cooling plate 3. If the angle α is excessively small (e.g., less than 5°), an area of a surface of the bottom wall 15 facing the cooling plate 3 cannot be effectively increased, and a heat dissipation effect of the cooling plate 3 on the inductor 2 cannot be effectively improved. Therefore, the angle α formed between the first surface and/or the second surface and the vertical direction should be selected within an appropriate range.

It can be understood that the angle between the first surface and the vertical direction and the angle between the second surface and the vertical direction may be the same or different.

In addition, during manufacturing of the mounting box 1, providing the angle α between the first surface and/or the second surface and the vertical direction can reduce difficulty of demolding the mounting box 1 and increase a manufacturing yield of the mounting box 1.

In some embodiments, as shown in FIG. 2 and FIG. 3, along the direction towards the cooling plate 3, a thickness of the first side wall 11 and/or the second side wall 12 increases, a receiving cavity 1b in a shape of a triangular prism is provided in the first side wall 11 and/or the second side wall 12, and a liquid cooling medium is received in the receiving cavity 1b. The cooling medium is capable of being transformed to be a gaseous state when a preset temperature is reached. The preset temperature may be an upper limit of an appropriate operation temperature of the inductor 2, or slightly higher than the upper limit, or slightly lower than the upper limit.

In some embodiments, as shown in FIG. 2 and FIG. 3, along the direction towards the cooling plate 3, a thickness of the first side wall 11 and/or the second side wall 12 increases, so that a distance between a surface of the first side wall 11 facing the second side wall 12 and a surface of the second side wall 12 facing the first side wall 11 is basically the same, and a shape of the mounting cavity 1a matches a shape of the inductor 2, thereby preventing shaking of the inductor 2 in the mounting cavity 1a.

By means of the arrangement of the receiving cavity 1b in the first side wall 11 and/or the second side wall 12, a cooling medium that can undergo phase change is filled into the receiving cavity 1b, so that when the inductor 2 is in operation, the liquid cooling medium absorbs heat generated by the inductor to heats up; and when the temperature rises to a preset temperature, the liquid cooling medium can continuously absorb heat to be converted to be a gaseous state. In this way, the cooling medium is more capable of absorbing heat, thereby effectively preventing an excessively high temperature of the inductor 2.

The receiving cavity 1b is in a shape of a triangular prism, so that a distance from a side wall of the receiving cavity 1b to the first surface is substantially consistent or a distance from a side wall of the receiving cavity 1b to a surface of the first side wall 11 facing the second side wall 12 is substantially consistent. At the same time, a side wall of the receiving cavity 1b in a shape of a triangular prism that faces the cooling plate 3 has a large area, which is conducive to transferring heat to the cooling plate 3. That is, the heat generated by the inductor 2 can be transferred to the cooling medium in the receiving cavity 1b, then transferred to the cooling plate 3, and finally taken away by the coolant in the cooling plate 3.

It can be understood that the receiving cavity 1b may be in other shape, which is not limited in the present disclosure.

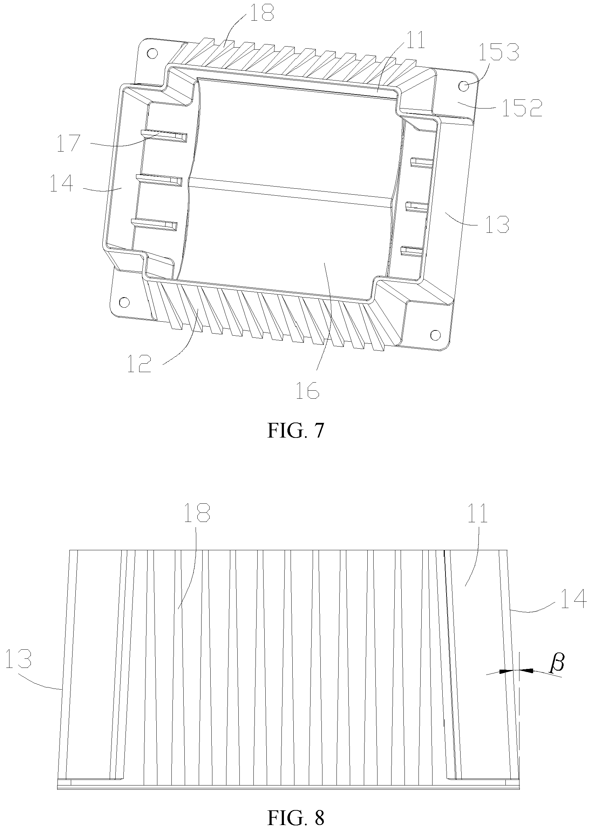

In some embodiments, as shown in FIG. 7, the first surface and/or the second surface may be provided with a heat dissipation rib 18, and the heat dissipation rib 18 may extend from an end of the first surface or the second surface away from the cooling plate 3 towards an end close to the cooling plate 3.

In some embodiments, as shown in FIG. 7, when wind flows through the first surface or the second surface, the heat of the mounting box can be transferred to the flowing wind, that is, air cooling heat dissipation. The arrangement of the heat dissipation rib 18 at the first surface and/or the second surface can increase a surface area of the mounting box 1 and improve an air cooling heat dissipation effect, thereby improving the heat dissipation effect on the inductor 2 and making the inductor 2 operate at an appropriate temperature. At the same time, the heat dissipation rib 18 extend from the end of the first surface or the second surface away from the cooling plate 3 to the end close to the cooling plate 3, thereby increasing a proportion of transfer of the heat to the cooling plate 3, thereby making the temperature of the inductor 2 more balanced.

In some embodiments, as shown in FIG. 7 and FIG. 8, along the direction towards the cooling plate 3, a width of the heat dissipation rib 18 increases, thereby increasing the proportion of transfer of the heat to the cooling plate 3 and further improves the heat dissipation effect of the cooling plate 3. At the same time, along the direction towards the cooling plate 3, a distance between adjacent heat dissipation ribs 18 gradually decreases. That is, the distance between adjacent heat dissipation ribs 18 is greater in a region away from the cooling plate 3 than in a region close to the cooling plate 3. Within a certain range, as the distance between adjacent heat dissipation ribs 18 increases, an air cooling effect is improved. Therefore, such a structure allows a region of the mounting box 1 away from the cooling plate 3 to be mainly air-cooled and supplemented by liquid cooling, and a region of the mounting box 1 close to the cooling plate 3 to be mainly liquid-cooled and supplemented by air cooling, thereby making an overall heat dissipation effect of the first side wall 11 and the second side wall 12 relatively uniform, which reduces a temperature difference at different positions of the inductor 2.

The width of the heat dissipation rib 18 may range from 1.5 mm to 2 mm, and the distance between the adjacent heat dissipation ribs 18 may range from 1.5 mm to 3 mm. For example, the width of the heat dissipation rib 18 may be 1.5 mm, 1.6 mm, 1.7 mm, 1.8 mm, 1.9 mm, 2 mm, or the like. The distance between adjacent heat dissipation ribs 18 may be 1.5 mm, 1.8 mm, 2 mm, 2.2 mm, 2.5 mm, 2.8 mm, or 3.0 mm.

The width of the heat dissipation rib 18 should not be excessively large or excessively small. If the width of the heat dissipation rib 18 is excessively large (e.g., greater than 2 mm), a number of heat dissipation ribs 18 that can be arranged at the first side wall 11 or the second side wall 12 is limited, which reduces the air cooling effect and increases a weight and a cost of the mounting box 1. If the width of the heat dissipation rib 18 is excessively small (e.g., smaller than 1.5 mm), strength of the heat dissipation rib 18 may be reduced, which easily damages the heat dissipation rib 18 and increases processing difficulty of the heat dissipation rib 18. Therefore, the width of the heat dissipation rib 18 ranging from 1.5 mm to 2 mm can ensure the heat dissipation effect and reduce the manufacturing cost of the mounting box 1.

The distance between the adjacent heat dissipation ribs 18 should not be excessively large or excessively small. If the distance between adjacent heat dissipation ribs 18 is excessively small (e.g., less than 1.5 mm), a gap between adjacent heat dissipation ribs 18 has small convection with the outside, and only a small amount of outside cold air can enter the gap, making the air cooling effect poor. If the distance between the adjacent heat dissipation ribs 18 is excessively large (e.g., greater than 3 mm), the number of heat dissipation ribs 18 that can be arranged at the first side wall 11 or the second side wall 12 is limited, also making the air cooling effect poor. Therefore, the distance between the adjacent heat dissipation ribs 18 ranging from 1.5 mm to 3 mm can ensure the air cooling heat dissipation effect of the mounting box 1.

In some embodiments, as shown in FIG. 7 and FIG. 8, along the direction towards the cooling plate 3, a height of the heat dissipation rib 18 protruding from the first side wall 11 or the second side wall 12 increases, which, on the one hand, increases the proportion of transfer of the heat to the cooling plate 3, and on the other hand, makes an area of the surface of the bottom wall 15 facing the cooling plate 3 larger, that is, an area of contact between the bottom wall 15 and the cooling plate 3 is larger.

In some embodiments, the heat dissipation rib 18 may extend along a straight line or extend in a wavy shape. When the heat dissipation rib 18 is in the wavy shape, an area of contact between the heat dissipation rib 18 and the air is increased, thereby improving the air cooling heat dissipation effect.

Further, as shown in FIG. 2 and FIG. 3, an angle γ is formed between the heat dissipation rib 18 and the vertical direction, and the angle γ satisfies 6°≤γ≤35°. For example, the angle γ may be 6°, 10°, 12°, 15°, 18°, 20°, 22°, 25°, 28°, 30°, 35°, or the like.

The angle γ formed between the heat dissipation rib 18 and the vertical direction should not be excessively large or excessively small. If the angle γ is excessively large (e.g., greater than 35°), the mounting box 1 may occupy an excessively large space, making it more difficult to arrange the mounting box 1 at the cooling plate 3. If the angle γ is excessively small (e.g., less than 6°), the height of the heat dissipation rib 18 protruding from the first surface or the second surface is limited, and heat dissipation cannot be well performed through air cooling. Therefore, the angle γ between the heat dissipation rib 18 and the vertical direction should be selected within a reasonable range. In addition, the angle γ between the heat dissipation rib 18 and the vertical direction should be larger than the angle α between the first surface and/or the second surface and the vertical direction, so that the heat dissipation rib 18 can protrude from the first surface or the second surface, and the protruding height gradually changes.

In addition, during manufacturing of the mounting box 1, providing the angle γ between the heat dissipation rib 18 and the vertical direction can reduce difficulty of demolding the mounting box 1 and increase a manufacturing yield of the mounting box 1.

In some embodiments, as shown in FIG. 2, FIG. 3, and FIG. 7, the mounting box 1 is provided therein with a first support portion 16 and a second support portion 17. The first support portion 16 includes an arc surface capable of supporting the main body 21. The second support portion 17 is arranged at each of two sides of the first support portion 16 along an axial direction of the inductor 2. The second support portion 17 is a support rib, and the support rib can support the end portion 22.

In some embodiments, as shown in FIG. 6 and FIG. 7, the main body 21 of the inductor 2 is partially in the shape of multiple cylinders, so the first support portion 16 having the arc surface can support the main body 21 of the inductor 2. Each of the two end portions 22 of the inductor 2 can be supported by the second support portion 17. The second support portion 17 allows a certain gap between the surface of the main body 21 and the first support portion 16 to ensure normal operation of the inductor. To ensure the heat dissipation effect on the inductor 2, thermal conductive glue with which the gap is filled is provided between the main body 21 and the first support portion 16. A gap between a surface of the main body 21 and the first support portion 16 ranges from 2 mm to 3 mm. That is, a thickness of the thermal conductive glue ranges from 2 mm to 3 mm.

For example, the second support portion 17 includes a plurality of support ribs arranged at intervals. The plurality of support ribs extend along the axial direction of the inductor 2, thereby reducing a weight of the second support portion 17 while support is provided for the end portions 22 of the inductor 2 and reducing the weight of the mounting box 1.

For example, the first support portion 16 may include two arc surfaces arranged side by side, and a section region formed by two edges of the arc surface extending along an axial direction thereof and an axis of the arc surface has an angle ranging from 120° to 175°, for example, 145°. It can be understood that when the mounting cavity 1a is designed to receive a plurality of inductors 2, the first support portion 16 is correspondingly configured to include a plurality of arc surfaces. The degree of the angle of the section region is not limited in the present disclosure.

Further, the shapes of the heat dissipation protrusions 151 and the heat dissipation grooves 32 can also match the shape of the first support portion 16, thereby improving the heat dissipation effect of the cooling plate 3 on the inductor 2.

Furthermore, the shape of the flow channel 31 arranged at the cooling plate 3 corresponding to the mounting box 1 also matches the shape of the first support portion 16.

In some embodiments, as shown in FIG. 7 and FIG. 8, the mounting box 1 includes a third side wall 13 and a fourth side wall 14 opposite to each other. The third side wall 13 includes a third surface facing away from the fourth side wall 14, and the fourth side wall 14 includes a fourth surface facing away from the third side wall 13. Along the direction towards the cooling plate 3, a distance between the third surface and the fourth surface increases.

In such embodiments, as shown in FIG. 7 and FIG. 8, along the direction towards the cooling plate 3, the distance between the third surface and the fourth surface increases, so that an area of a surface of the bottom wall 15 facing the cooling plate 3 is larger, that is, the area of contact between the bottom wall 15 and the cooling plate 3 is larger. As a result, heat exchange efficiency between the mounting box 1 and the cooling plate 3 is higher, and the cooling plate 3 has a better heat dissipation effect on the inductor 2.

It can be understood that the third side wall 13 and the fourth side wall 14 may also be provided with the heat dissipation rib 18.

For example, the structure of the heat dissipation rib 18 arranged at the third side wall 13 and the fourth side wall 14 may be the same as the structure of the heat dissipation rib 18 arranged at the first side wall 11 and the second side wall 12. That is, the heat dissipation rib 18 arranged at the third side wall 13 or the fourth side wall 14 extends from the end of the third surface or the fourth surface away from the cooling plate 3 to the end close to the cooling plate 3. Along the direction towards the cooling plate 3, a width of the heat dissipation rib 18 arranged at the third side wall 13 or the fourth side wall 14 increases. The width of the heat dissipation rib 18 arranged at the third side wall 13 or the fourth side wall 14 ranges from 1.5 mm to 2 mm. A distance between adjacent heat dissipation ribs 18 ranges from 1.5 mm to 3 mm.

It can be understood that the structure of the heat dissipation rib 18 arranged at the third side wall 13 and the fourth side wall 14 may be different from the structure of the heat dissipation rib 18 arranged at the first side wall 11 and the second side wall 12. For example, the heat dissipation rib 18 arranged at the third side wall 13 or the fourth side wall 14 may extend along a direction from the first side wall 11 towards the second side wall 12. The heat dissipation rib 18 arranged at the third side wall 13 or the fourth side wall 14 may be in a wavy shape.

For example, as shown in FIG. 8, an angle β is formed between the third surface and/or the fourth surface and the vertical direction, and the angle β may satisfy 2°≤β≤15°. For example, the angle β may be 2°, 3°, 5°, 8°, 10°, 12°, 14°, 15°, or the like.

The angle β formed between the third surface and/or the fourth surface and the vertical direction should not be excessively large or excessively small. If the angle β is excessively large (e.g., greater than 15°), the mounting box 1 may occupy an excessively large space, making it more difficult to arrange the mounting box 1 at the cooling plate 3. If the angle β is excessively small (e.g., less than 2°), an area of a surface of the bottom wall 15 facing the cooling plate 3 cannot be effectively increased, and a heat dissipation effect of the cooling plate 3 on the inductor 2 cannot be effectively improved. Therefore, the angle β between the third surface and/or the fourth surface and the vertical direction should be selected within an appropriate range.

It can be understood that the angle formed between the third surface and the vertical direction and the angle formed between the fourth surface and the vertical direction may be the same or different.

In addition, during manufacturing of the mounting box 1, providing the angle β between the third surface and/or the fourth surface and the vertical direction can reduce difficulty of demolding the mounting box 1 and increase a manufacturing yield of the mounting box 1.

In some embodiments, a fan may be provided in the energy storage converter. The fan is arranged at one or two sides in the extension direction of the heat dissipation rib 18, thereby speeding up flow of air between the heat dissipation ribs 18 and improving the air cooling effect.

For example, when the heat dissipation rib 18 extends from the end away from the cooling plate 3 to the end close to the cooling plate 3, the fan may be arranged at a side of the mounting box 1 away from the cooling plate 3, that is, above the mounting box 1, so that the fans can blow the air between adjacent heat dissipation ribs 18 to the cooling plate 3 to improve the heat dissipation effect of the cooling plate 3. When the heat dissipation rib 18 arranged at the third side wall 13 and the fourth side wall 14 extends along a direction from the first side wall 11 towards the second side wall 12, the fan may be arranged at a corner of the mounting box 1, for example, two opposite corners of the mounting box 1 or two corners connected to the first side wall 11 or the second side wall 12.

In some embodiments, as shown in FIG. 5 and FIG. 7, the mounting box 1 includes an avoidance groove 19, and the avoidance groove 19 may be arranged at a junction of the first side wall 11 with the third side wall 13 and the fourth side wall 14 and at a junction of the second side wall 12 with the third side wall 13 and the fourth side wall 14. The bottom wall 15 includes a mounting surface 152 at a side facing the avoidance groove 19, the mounting surface 152 is provided with a mounting hole 153, and a connecting member passes through the mounting hole 153 to be connected to the cooling plate 3. The connecting member may be a fastener such as a bolt or a screw.

In such embodiments, as shown in FIG. 5 and FIG. 7, the connecting member passes through the mounting hole 153 to be connected to the cooling plate 3, which can firmly fix the mounting box 1 to the cooling plate 3 to prevent separation of the mounting box 1 from the cooling plate 3. Through the arrangement of the avoidance groove 19 at each of four corners of the mounting box 1, a necessary operating space can be provided for mounting the connecting member, so that the connecting member can be mounted to the mounting box 1 smoothly and conveniently. At the same time, the avoidance groove 19 makes two ends of each of the first side wall 11, the second side wall 12, the third side wall 13 and the fourth side wall 14 be recessed towards interior of the mounting cavity 1a, and the recess can abut against the inductor 2, thereby limiting the position of the inductor 2 in the mounting cavity 1a. In this way, the inductor 2 cannot move randomly in the mounting cavity 1a, thereby improving stability of operation of the inductor 2.

Further, as shown in FIG. 2 and FIG. 3, a width of the flow channel 31 arranged at the cooling plate 3 corresponding to the mounting box 1 is less than a distance between two mounting holes 153 distributed along the width direction of the mounting box 1, so that the mounting of the connecting member cannot damage the flow channel 31, thereby preventing leakage of the coolant in the flow channel 31.

Furthermore, the axial direction of the inductor 2 is parallel to a flow direction of the coolant in the flow channel 31 arranged at the cooling plate 3 corresponding to the mounting box 1. A plurality of mounting boxes 1 may be arranged at the cooling plate 3 at intervals along the flow direction of the coolant in the flow channel 31.

In some embodiments, as shown in FIG. 1 and FIG. 2, the mounting box 1 does not include a top cover. That is, the mounting cavity 1a may be communicated with the outside through the top. The inductor 2 mounted in the mounting cavity 1a may be electrically connected to other electronic components in the energy storage converter through the top of the mounting box 1. At the same time, the top of the mounting box 1 can also improve the heat dissipation effect of the inductor 2.

The above-described embodiments are merely preferred embodiments of the present disclosure and are not intended to limit the present disclosure. Various changes and modifications can be made to the present disclosure by those skilled in the art.

## Claims

1. An energy storage converter, comprising:
a mounting box (1);
an inductor (2); and
a cooling plate (3),
wherein the mounting box (1) comprises a mounting cavity (1a), the inductor (2) is mounted in the mounting cavity (1a), and the mounting box (1) is mounted to the cooling plate (3);
wherein the mounting box (1) comprises a bottom wall (15), one of the bottom wall (15) and the cooling plate (3) is provided with a heat dissipation protrusion (151) and the other one of the bottom wall (15) and the cooling plate (3) is provided with a heat dissipation groove (32), and the heat dissipation protrusion (151) is engaged with the heat dissipation groove (32);
wherein the mounting box (1) comprises a first side wall (11) and a second side wall (12) opposite to each other, the first side wall (11) comprises a first surface facing away from the second side wall (12), the second side wall (12) comprises a second surface facing away from the first side wall (11), **characterised in that** a distance between the first surface and the second surface gradually increases along a direction towards the cooling plate (3); and **in that** a thickness of the first side wall (11) and/or the second side wall (12) increases along the direction towards the cooling plate (3).

2. The energy storage converter according to claim 1, wherein a plurality of heat dissipation protrusions (151) and/or a plurality of heat dissipation grooves (32) are arranged along an axial direction of the inductor (2).

3. The energy storage converter according to claim 1, wherein a thermal conductive glue is applied to the heat dissipation protrusion (151) and the heat dissipation groove (32), and a gap between the heat dissipation protrusion (151) and the heat dissipation groove (32) is filled with the thermal conductive glue.

4. The energy storage converter according to claim 1, wherein the cooling plate (3) is provided therein with a flow channel (31), and coolant at a low temperature is introduced into the flow channel (31).

5. The energy storage converter according to claim 4, wherein a shape of the flow channel (31) matches a shape of the heat dissipation protrusion (151) or the heat dissipation groove (32).

6. The energy storage converter according to claim 1, wherein the first surface and/or the second surface are/is provided with a heat dissipation rib (18), and the heat dissipation rib (18) extends from an end of the first surface or the second surface away from the cooling plate (3) towards an end close to the cooling plate (3).

7. The energy storage converter according to claim 6,
wherein a width of the heat dissipation rib (18) increases along the direction towards the cooling plate (3); and/or
wherein a height of the heat dissipation rib (18) protruding from the first side wall (11) or the second side wall (12) increases along the direction towards the cooling plate (3).

8. The energy storage converter according to claim 6, wherein a plurality of heat dissipation ribs (18) are provided, and a distance between adjacent heat dissipation ribs (18) decreases along the direction towards the cooling plate (3).

9. The energy storage converter according to claim 1,
wherein a receiving cavity (1b) in a shape of a triangular prism is formed in the first side wall (11) and/or the second side wall (12), a liquid cooling medium is received in the receiving cavity (1b), and the cooling medium is capable of being transformed to be a gaseous state when a preset temperature is reached.

10. The energy storage converter according to claim 9, wherein a distance from a side wall of the receiving cavity (1b) to the first surface is substantially consistent, or a distance from a side wall of the receiving cavity (1b) to a surface of the first side wall (11) facing the second side wall (12) is substantially consistent.

11. The energy storage converter according to claim 1,
wherein the inductor (2) comprises a main body (21) and end portions (22), and the end portions (22) are arranged at two sides of the main body (21); and
wherein the mounting box (1) is provided with:
a first support portion (16), the first support portion (16) comprising an arc surface capable of supporting the main body (21); and
a second support portion (17), the second support portion (17) being arranged at each of two sides of the first support portion (16) along an axial direction of the inductor (2), the second support portion (17) being a support rib, and the support rib being capable of supporting each of the end portions (22).

12. The energy storage converter according to claim 1, wherein an angle α is formed between the first surface and/or the second surface and a vertical direction, and the angle α satisfies 5°≤α≤30°.

13. The energy storage converter according to any one of claims 1 to 12, wherein the mounting box (1) comprises a third side wall (13) and a fourth side wall (14) opposite to each other, the third side wall (13) comprise a third surface facing away from the fourth side wall (14), the fourth side wall (14) comprises a fourth surface facing away from the third side wall (13), and a distance between the third surface and the fourth surface increases along the direction towards the cooling plate (3).

14. The energy storage converter according to claim 13,
wherein the mounting box (1) comprises avoidance grooves (19), and the avoidance grooves (19) are arranged at a junction of the first side wall (11) with the third side wall (13), at a junction of the first side wall (11) with the fourth side wall (14), at a junction of the second side wall (12) with the third side wall (13), and at a junction of the second side wall (12) with the fourth side wall (14); and
wherein the bottom wall (15) comprises a mounting surface (152) at a side facing each of the avoidance grooves (19), the mounting surface (152) is with a mounting hole (153), and a connecting member passes through the mounting hole (153) to be connected to the cooling plate (3).

15. An energy storage device, comprises a body and the energy storage converter according to any one of claims 1 to 14.

## Patentansprüche

1. Energiespeicherwandler, umfassend:
einen Montagekasten (1);
einen Induktor (2); und
eine Kühlplatte (3),
wobei der Montagekasten (1) einen Montagehohlraum (1a) umfasst, der Induktor (2) in dem Montagehohlraum (1a) montiert ist und der Montagekasten (1) an der Kühlplatte (3) montiert ist;
wobei der Montagekasten (1) eine Bodenwand (15) umfasst, eines von der Bodenwand (15) und der Kühlplatte (3) mit einem Wärmeableitungsvorsprung (151) bereitgestellt ist und das andere von der Bodenwand (15) und der Kühlplatte (3) mit einer Wärmeableitungsnut (32) bereitgestellt ist, und der Wärmeableitungsvorsprung (151) mit der Wärmeableitungsnut (32) in Eingriff steht;
wobei der Montagekasten (1) eine erste Seitenwand (11) und eine zweite Seitenwand (12) umfasst, die einander gegenüberliegen, die erste Seitenwand (11) eine erste Oberfläche umfasst, die von der zweiten Seitenwand (12) abgewandt ist, die zweite Seitenwand (12) eine zweite Oberfläche umfasst, die von der ersten Seitenwand (11) abgewandt ist, **dadurch gekennzeichnet, dass**
ein Abstand zwischen der ersten Oberfläche und der zweiten Oberfläche entlang einer Richtung zu der Kühlplatte (3) hin allmählich zunimmt; und **dadurch, dass**
eine Dicke der ersten Seitenwand (11) und/oder der zweiten Seitenwand (12) entlang der Richtung zu der Kühlplatte (3) hin zunimmt.

2. Energiespeicherwandler nach Anspruch 1, wobei eine Vielzahl von Wärmeableitungsvorsprüngen (151) und/oder eine Vielzahl von Wärmeableitungsnuten (32) entlang einer axialen Richtung des Induktors (2) angeordnet sind.

3. Energiespeicherwandler nach Anspruch 1, wobei ein wärmeleitfähiger Klebstoff auf den Wärmeableitungsvorsprung (151) und die Wärmeableitungsnut (32) aufgebracht ist und ein Spalt zwischen dem Wärmeableitungsvorsprung (151) und der Wärmeableitungsnut (32) mit dem wärmeleitfähigen Klebstoff gefüllt ist.

4. Energiespeicherwandler nach Anspruch 1, wobei die Kühlplatte (3) darin mit einem Strömungskanal (31) bereitgestellt ist und Kühlmittel mit einer niedrigen Temperatur in den Strömungskanal (31) eingeleitet wird.

5. Energiespeicherwandler nach Anspruch 4, wobei eine Form des Strömungskanals (31) mit einer Form des Wärmeableitungsvorsprungs (151) oder der Wärmeableitungsnut (32) übereinstimmt.

6. Energiespeicherwandler nach Anspruch 1, wobei die erste Oberfläche und/oder die zweite Oberfläche mit einer Wärmeableitungsrippe (18) bereitgestellt ist, und sich die Wärmeableitungsrippe (18) von einem Ende der ersten Oberfläche oder der zweiten Oberfläche weg von der Kühlplatte (3) zu einem Ende nahe der Kühlplatte (3) erstreckt.

7. Energiespeicherwandler nach Anspruch 6,
wobei eine Breite der Wärmeableitungsrippe (18) entlang der Richtung zu der Kühlplatte (3) hin zunimmt; und/oder
wobei eine Höhe der Wärmeableitungsrippe (18), die von der ersten Seitenwand (11) oder der zweiten Seitenwand (12) vorsteht, entlang der Richtung zu der Kühlplatte (3) hin zunimmt.

8. Energiespeicherwandler nach Anspruch 6, wobei eine Vielzahl von Wärmeableitungsrippen (18) bereitgestellt ist und ein Abstand zwischen benachbarten Wärmeableitungsrippen (18) entlang der Richtung zu der Kühlplatte (3) hin abnimmt.

9. Energiespeicherwandler nach Anspruch 1,
wobei ein Aufnahmehohlraum (1b) in einer Form eines dreieckigen Prismas in der ersten Seitenwand (11) und/oder der zweiten Seitenwand (12) ausgebildet ist, ein flüssiges Kühlmedium in dem Aufnahmehohlraum (1b) aufgenommen ist und das Kühlmedium in der Lage ist, in einen gasförmigen Zustand umgewandelt zu werden, wenn eine voreingestellte Temperatur erreicht wird.

10. Energiespeicherwandler nach Anspruch 9, wobei ein Abstand von einer Seitenwand des Aufnahmehohlraums (1b) zu der ersten Oberfläche im Wesentlichen gleichbleibend ist, oder ein Abstand von einer Seitenwand des Aufnahmehohlraums (1b) zu einer Oberfläche der ersten Seitenwand (11), die der zweiten Seitenwand (12) zugewandt ist, im Wesentlichen gleichbleibend ist.

11. Energiespeicherwandler nach Anspruch 1,
wobei der Induktor (2) einen Grundkörper (21) und Endabschnitte (22) umfasst, und die Endabschnitte (22) an zwei Seiten des Grundkörpers (21) angeordnet sind; und
wobei der Montagekasten (1) bereitgestellt ist mit:
einem ersten Stützabschnitt (16), der erste Stützabschnitt (16) umfassend eine Bogenoberfläche, die geeignet ist, den Grundkörper (21) zu stützen; und
einen zweiten Stützabschnitt (17), wobei der zweite Stützabschnitt (17) an jeder von zwei Seiten des ersten Stützabschnitts (16) entlang einer axialen Richtung des Induktors (2) angeordnet ist, wobei der zweite Stützabschnitt (17) eine Stützrippe ist und die Stützrippe in der Lage ist, jeden der Endabschnitte (22) zu stützen.

12. Energiespeicherwandler nach Anspruch 1, wobei ein Winkel α zwischen der ersten Oberfläche und/oder der zweiten Oberfläche und einer vertikalen Richtung ausgebildet ist und der Winkel α 5°≤α≤30° erfüllt.

13. Energiespeicherwandler nach einem der Ansprüche 1 bis 12, wobei der Montagekasten (1) eine dritte Seitenwand (13) und eine vierte Seitenwand (14) umfasst, die einander gegenüberliegen, die dritte Seitenwand (13) eine dritte Oberfläche umfasst, die von der vierten Seitenwand (14) abgewandt ist, die vierte Seitenwand (14) eine vierte Oberfläche umfasst, die von der dritten Seitenwand (13) abgewandt ist, und ein Abstand zwischen der dritten Oberfläche und der vierten Oberfläche entlang der Richtung zu der Kühlplatte (3) hin zunimmt.

14. Energiespeicherwandler nach Anspruch 13,
wobei der Montagekasten (1) Ausweichnuten (19) umfasst, und die Ausweichnuten (19) an einer Verbindungsstelle der ersten Seitenwand (11) mit der dritten Seitenwand (13), an einer Verbindungsstelle der ersten Seitenwand (11) mit der vierten Seitenwand (14), an einer Verbindungsstelle der zweiten Seitenwand (12) mit der dritten Seitenwand (13) und an einer Verbindungsstelle der zweiten Seitenwand (12) mit der vierten Seitenwand (14) angeordnet sind; und
wobei die Bodenwand (15) eine Montageoberfläche (152) an einer Seite umfasst, die jeder der Ausweichnuten (19) zugewandt ist, wobei die Montageoberfläche (152) mit einem Montageloch (153) ist und ein Verbindungselement durch das Montageloch (153) hindurchtritt, um mit der Kühlplatte (3) verbunden zu werden.

15. Energiespeichervorrichtung, die einen Körper und den Energiespeicherwandler nach einem der Ansprüche 1 bis 14 umfasst.

## Revendications

1. Convertisseur de stockage d'énergie, comprenant :
un boîtier de montage (1) ;
un inducteur (2) ; et
une plaque de refroidissement (3),
dans lequel le boîtier de montage (1) comprend une cavité de montage (1a), l'inducteur (2) est monté dans la cavité de montage (1a), et le boîtier de montage (1) est monté à la plaque de refroidissement (3) ;
dans lequel le boîtier de montage (1) comprend une paroi inférieure (15), l'une parmi la paroi inférieure (15) et la plaque de refroidissement (3) est pourvue d'une partie saillante de dissipation de chaleur (151) et l'autre parmi la paroi inférieure (15) et la plaque de refroidissement (3) est pourvue d'une rainure de dissipation de chaleur (32), et la partie saillante de dissipation de chaleur (151) est en prise avec la rainure de dissipation de chaleur (32) ;
dans lequel le boîtier de montage (1) comprend une première paroi latérale (11) et une deuxième paroi latérale (12) opposées l'une à l'autre, la première paroi latérale (11) comprend une première surface faisant face à l'écart de la deuxième paroi latérale (12), la deuxième paroi latérale (12) comprend une deuxième surface faisant face à l'écart de la première paroi latérale (11), **caractérisé en ce que**
une distance entre la première surface et la deuxième surface augmente progressivement le long d'une direction allant vers la plaque de refroidissement (3) ; et **en ce que**
une épaisseur de la première paroi latérale (11) et/ou de la deuxième paroi latérale (12) augmente le long de la direction allant vers la plaque de refroidissement (3).

2. Convertisseur de stockage d'énergie selon la revendication 1, dans lequel une pluralité de parties saillantes de dissipation de chaleur (151) et/ou une pluralité de rainures de dissipation de chaleur (32) sont agencées le long d'une direction axiale de l'inducteur (2).

3. Convertisseur de stockage d'énergie selon la revendication 1, dans lequel une colle thermoconductrice est appliquée sur la partie saillante de dissipation de chaleur (151) et la rainure de dissipation de chaleur (32), et un espace entre la partie saillante de dissipation de chaleur (151) et la rainure de dissipation de chaleur (32) est rempli avec la colle thermoconductrice.

4. Convertisseur de stockage d'énergie selon la revendication 1, dans lequel la plaque de refroidissement (3) est pourvue en son sein d'un canal d'écoulement (31), et un caloporteur à basse température est introduit dans le canal d'écoulement (31).

5. Convertisseur de stockage d'énergie selon la revendication 4, dans lequel une forme du canal d'écoulement (31) concorde avec une forme de la partie saillante de dissipation de chaleur (151) ou de la rainure de dissipation de chaleur (32).

6. Convertisseur de stockage d'énergie selon la revendication 1, dans lequel la première surface et/ou la deuxième surface est/sont pourvues d'une nervure de dissipation de chaleur (18), et la nervure de dissipation de chaleur (18) s'étend à partir d'une extrémité de la première surface ou de la deuxième surface à l'écart de la plaque de refroidissement (3) en direction d'une extrémité près de la plaque de refroidissement (3).

7. Convertisseur de stockage d'énergie selon la revendication 6,
dans lequel une largeur de la nervure de dissipation de chaleur (18) augmente le long de la direction allant vers la plaque de refroidissement (3) ; et/ou
dans lequel une hauteur de la nervure de dissipation de chaleur (18) faisant saillie de la première paroi latérale (11) ou de la deuxième paroi latérale (12) augmente le long de la direction allant vers la plaque de refroidissement (3).

8. Convertisseur de stockage d'énergie selon la revendication 6, dans lequel une pluralité de nervures de dissipation de chaleur (18) sont fournies, et une distance entre des nervures de dissipation de chaleur (18) adjacentes diminue le long de la direction allant vers la plaque de refroidissement (3).

9. Convertisseur de stockage d'énergie selon la revendication 1,
dans lequel une cavité de réception (1b) sous une forme d'un prisme triangulaire est formée dans la première paroi latérale (11) et/ou la deuxième paroi latérale (12), un milieu de refroidissement liquide est reçu dans la cavité de réception (1b), et le milieu de refroidissement est capable d'être transformé pour être dans un état gazeux lorsqu'une température prédéfinie est atteinte.

10. Convertisseur de stockage d'énergie selon la revendication 9, dans lequel une distance allant d'une paroi latérale de la cavité de réception (1b) à la première surface est sensiblement constante, ou une distance allant d'une paroi latérale de la cavité de réception (1b) à une surface de la première paroi latérale (11) faisant face vers la deuxième paroi latérale (12) est sensiblement constante.

11. Convertisseur de stockage d'énergie selon la revendication 1,
dans lequel l'inducteur (2) comprend un corps principal (21) et des parties d'extrémité (22), et les parties d'extrémité (22) sont agencées au niveau de deux côtés du corps principal (21) ; et
dans lequel le boîtier de montage (1) est pourvu de :
une première partie de support (16), la première partie de support (16) comprenant une surface d'arc capable de supporter le corps principal (21) ; et
une seconde partie de support (17), la seconde partie de support (17) étant agencée au niveau de chacun des deux côtés de la première partie de support (16) le long d'une direction axiale de l'inducteur (2), la seconde partie de support (17) étant une nervure de support, et la nervure de support étant capable de supporter chacune des parties d'extrémité (22).

12. Convertisseur de stockage d'énergie selon la revendication 1, dans lequel un angle α est formé entre la première surface et/ou la deuxième surface et une direction verticale, et l'angle α respecte 5°≤α≤30°.

13. Convertisseur de stockage d'énergie selon l'une quelconque des revendications 1 à 12, dans lequel le boîtier de montage (1) comprend une troisième paroi latérale (13) et une quatrième paroi latérale (14) opposées l'une à l'autre, la troisième paroi latérale (13) comprend une troisième surface faisant face à l'écart de la quatrième paroi latérale (14), la quatrième paroi latérale (14) comprend une quatrième surface faisant face à l'écart de la troisième paroi latérale (13), et une distance entre la troisième surface et la quatrième surface augmente le long de la direction allant vers la plaque de refroidissement (3).

14. Convertisseur de stockage d'énergie selon la revendication 13,
dans lequel le boîtier de montage (1) comprend des rainures d'évitement (19), et les rainures d'évitement (19) sont agencées au niveau d'une jonction de la première paroi latérale (11) avec la troisième paroi latérale (13), au niveau d'une jonction de la première paroi latérale (11) avec la quatrième paroi latérale (14), au niveau d'une jonction de la deuxième paroi latérale (12) avec la troisième paroi latérale (13), et au niveau d'une jonction de la deuxième paroi latérale (12) avec la quatrième paroi latérale (14) ; et
dans lequel la paroi inférieure (15) comprend une surface de montage (152) au niveau d'un côté faisant face vers chacune des rainures d'évitement (19), la surface de montage (152) est avec un trou de montage (153), et un élément de liaison passe à travers le trou de montage (153) pour être relié à la plaque de refroidissement (3).

15. Dispositif de stockage d'énergie, qui comprend un corps et le convertisseur de stockage d'énergie selon l'une quelconque des revendications 1 à 14.
